# EUROPEAN PATENT APPLICATION

(11) **EP 2 781 576 A1**
(43) Date of publication of application: **24.09.2014**
(21) Application number: 14156657.0
(22) Date of filing: 25.02.2014
(51) Int. Cl.: C09K 11/77, H01L 33/50

(54) **Phosphor, light-emitting device and method for producing the phosphor**

(30) Priority: 18.03.2013 JP 2013055455
(71) Applicant: Kabushiki Kaisha Toshiba, Tokyo 105-8001 (JP)
(72) Inventor: Fukuda, Yumi, Minato-ku, Tokyo 105-8001 (JP); Albessard, Keiko, Minato-ku, Tokyo 105-8001 (JP); Mitsuishi, Iwao, Minato-ku, Tokyo 105-8001 (JP)
(74) Representative: Granleese, Rhian Jane

(57) **Abstract**

The present disclosure provides a phosphor excellent in temperature characteristic and capable of highly efficiently emitting yellow light with a wide half-width in the emission spectrum. This phosphor emits luminescence with a peak wavelength of 500 to 600 nm under excitation by light with a peak wavelength of 250 to 500 nm, and is represented by the following formula (1):

(M₁₋ₓCeₓ)_{2y}Al_{z}Si_{10-z}OᵤNᵥC_{w} (1)

[M is mainly Sr and may be partly replaced with at least one element selected from the group consisting of Ba, Ca and Mg; and x, y, z, u, v and w satisfy the conditions of 0<x≤1, 0.8≤y≤1.1, 2≤z≤3.5, 0<u≤1.5, 0.01≤w≤0.1 and 13≤u+v+w≤15, respectively].

## Description

### CROSS-REFERENCE TO RELATED APPLICATIONS

This application is based upon and claims the benefit of priority from the Japanese Patent Application No. 2013-055455, filed on March 18, 2013, the entire contents of which are incorporated herein by reference.

### FIELD

Embodiments of the present disclosure relate to a phosphor, a light-emitting device and a process for producing the phosphor.

### BACKGROUND

A white light-emitting device comprises a combination of, for example, a blue LED, a phosphor that emits red light under excitation by blue light, and another phosphor that emits green light under excitation by blue light. However, if containing a phosphor that emits yellow light under excitation by blue light, the white light-emitting device can be produced by use of fewer kinds of phosphors. As the yellow-light emitting phosphor, Eu-activated orthosilicate phosphors are known, for example.

Those yellow-emitting phosphors have been studied for various applications, and there are increasing demands for improvement of the phosphors in temperature characteristics, in quantum efficiency and in half-widths of their emission spectra.

### BRIEF DESCRIPTION OF THE DRAWINGS

Figure 1 shows a vertical sectional view schematically illustrating a light-emitting device according to an embodiment.
Figure 2 shows a vertical sectional view schematically illustrating a light-emitting device according to another embodiment.
Figure 3 shows an XRD pattern given by the phosphor of Example 1.

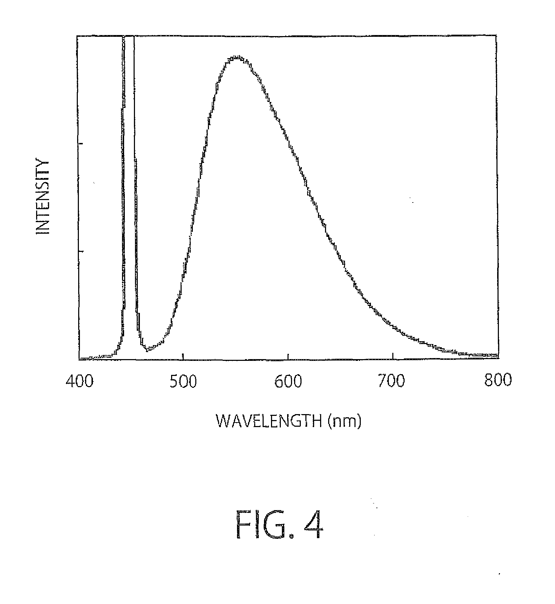

Figure 4 shows an emission spectrum given by the phosphor of Example 1 under excitation at 450 nm.
Figure 5 shows an XRD pattern given by the phosphor of Example 2.
Figure 6 shows an XRD pattern given by the phosphor of Example 3.
Figure 7 shows an XRD pattern given by the phosphor of Example 4.
Figure 8 shows an XRD pattern given by the phosphor of Example 5.
Figure 9 shows emission spectra given by the phosphors of Examples 1 to 5 and Comparative example under excitation at 450 nm.
Figure 10 shows a relation between the carbon contents (w) and the relative rates of absorption in Examples 1 to 5 and Comparative example under excitation at 450 nm.
Figure 11 shows a relation between the carbon contents (w) and the relative quantum efficiencies in Examples 1 to 5 and Comparative example under excitation at 450 nm.
Figure 12 shows a relation between the carbon contents (w) and the relative luminous efficiencies in Examples 1 to 5 and Comparative example under excitation at 450 nm.

### DETAILED DESCRIPTION

Embodiments will now be explained with reference to the accompanying drawings.

A phosphor according to the embodiment emits luminescence with a peak in the wavelength range of 500 to 600 nm under excitation by light with a peak in the wavelength range of 250 to 500 nm, and is represented by the following formula (1):

(M₁₋ₓCeₓ)_{2y}Al_{z}Si_{10-z}OᵤNᵥC_{w} (1)

in which
M is metal element comprising Sr, and
x, y, z, u, v and w satisfy the conditions of
0<x≤1,
0.8≤y≤1.1,
2≤z≤3.5,
0<u≤1.5,
0.01≤w≤0.1, and
13≤u+v+w≤15, respectively.

Since emitting luminescence with a peak wavelength of 500 to 600 nm under excitation by light with a peak wavelength of 250 to 500 nm, the phosphor according to the embodiment can give off light in the range of yellowish green to orange. The phosphor of the embodiment thus mainly emits light in the yellow range, and hence is hereinafter often referred to as "yellow-emitting phosphor". This phosphor has a matrix of essentially the same crystal structure as that of Sr₂Al₃Si₇ON₁₃, and the matrix is activated with Ce. The yellow-emitting phosphor according to the embodiment is represented by the following formula (1):

(M₁₋ₓCeₓ)₂yAl_{z}Si_{10-z}OᵤNᵥC_{w} (1)

in which
M is a metal element comprising Sr, and
x, y, z, u, v and w satisfy the conditions of
0<x≤1,
0.8≤y≤1.1,
2≤z≤3.5,
0<u≤1.5,
0.01≤w≤0.1, and
13≤u+v+w≤15, respectively.

As shown in the above formula (1), the metal element M is at least partly replaced with the emission center element Ce. The metal element M is basically Sr, namely Sr is contained in the largest amount of all the metals serving as M. M can further comprise at least one element selected from the group consisting of Ba, Ca and Mg. The metal element M other than Sr is preferably contained in a small amount so that variant phases may not be formed in the production process of the phosphor. Specifically, the amounts of Ba, Ca and Mg are preferably individually 10 at.% or less based on the total amount of M.

If the amount of Ce is 0.1 mol% or more based on the total amount of M and Ce, the phosphor can have sufficient luminous efficiency. Accordingly, x is preferably 0.001 or more. The metal element M may be completely replaced with Ce (that is, x may be 1), but x is preferably 0.5 or less so as to avoid decrease of the emission probability (namely, to avoid concentration quenching).

The yellow-emitting phosphor according to the embodiment contains Ce as an emission center element, and thereby emits light in the range of yellowish green to orange, namely, gives off luminescence with a peak in the wavelength range of 500 to 600 nm, under excitation by light with a peak in the wavelength range of 250 to 500 nm. Even if other elements are contained as unavoidable impurities in an amount of about 10 at.% or less based on the amount of Ce, they does not impair the aimed effect. Examples of the unavoidable impurities include Tb, Eu and Mn.

y is preferably 0.8 or more, further preferably 0.85 or more, so as to avoid formation of crystal defects and to prevent decrease of the efficiency. On the other hand, however, y is preferably 1.1 or less, further preferably 1.06 or less so that excess of the alkaline earth metal may not deposit in the form of variant phases to decrease the luminous efficiency. Accordingly, y satisfies the condition of 0.8≤x≤1.1 preferably, 0.85≤x≤1.06 more preferably.

z is preferably 2 or more, further preferably 2.2 or more so that excess Si may not deposit in the form of variant phases to decrease the luminous efficiency. On the other hand, however, z is preferably 3.5 or less, further preferably 3.3 or less so that excess Al may not deposit in the form of variant phases to decrease the luminous efficiency. Accordingly, z satisfies the condition of 2≤z≤3.5 preferably, 2.2≤z≤3.3 more preferably.

u is preferably 1 or less, further preferably 0.8 or less so that crystal defects may not increase to lower the luminous efficiency. On the other hand, however, u is preferably 0.001 or more so as to maintain the desired crystal structure and to keep properly the wavelength of the emission spectrum. Accordingly, u satisfies the condition of 0<u≤1.5 preferably, 0.001≤u≤1 more preferably.

The value of u+v+w satisfies the condition of preferably 13≤u+v+w≤15, more preferably 13.2≤u+v+w≤14.8 so that the phosphor of the embodiment can retain the desired crystal structure and also so that variant phases may not be formed in the production process of the phosphor.

Since satisfying all the above conditions, the phosphor according to the present embodiment can highly efficiently emit yellow light with a wide half-width in the emission spectrum under excitation by light with a peak in the wavelength range of 250 to 500 nm. Consequently, the phosphor enables to realize white light with a high color rendering property. Further, the yellow-emitting phosphor of the present embodiment is also excellent in temperature characteristics.

The yellow-emitting phosphor according to the present embodiment can be said to be based on Sr₂Al₃Si₇ON₁₃, but its constituting elements Sr, Si, Al, O and N are replaced with other elements and/or the matrix is fused with other metal elements such as Ce to form a solid solution. These modifications such as replacement often slightly change the crystal structure. However, the atomic positions therein are seldom changed so greatly as to break the chemical bonds among the skeleton atoms. Here, the atomic positions depend on the crystal structure, on the sites occupied by the atoms therein and on their atomic coordinates. The above formula (1) contains carbon, but it is not clear at present whether or not the oxygen or nitrogen atom is replaced with the carbon atom in the crystal structure. Even so, however, as a result of evaluation such as elemental analysis, it can be verified that the phosphor of the embodiment contains carbon in an amount specified by the formula (1).

The embodiment of the present disclosure can obtain the aimed effect as long as the yellow-emitting phosphor does not change its basic crystal structure. There may be a case where the crystal structure of the phosphor differs from that of Sr₂Al₃Si₇ON₁₃ in the lattice constants and/or in the chemical bond lengths (close interatomic distances) of M-N and M-O. However, even in that case, if the differences are within a range of ±15% based on the lattice constants or chemical bond lengths (Sr-N and Sr-O) in Sr₂Al₃Si₇ON₁₃, the crystal structures are defined as essentially the same. Here, the lattice constants can be determined by X-ray diffraction or neutron diffraction, and the chemical bond lengths (close interatomic distances) of M-N and M-O can be calculated from the atomic coordinates.

The Sr₂Al₃Si₇ON₁₃ crystal belongs to a monoclinic system, especially to an orthorhombic system with lattice constants of a=11.8 A, b=21.6 A and c=5.01 A. This crystal also belongs to the space group Pna21 (which is the 33^{rd} space group listed in International Tables for Crystallography, Volume A: Space-group symmetry, Edited by T. Hahn, Springer (Netherlands))). The chemical bond lengths (Sr-N and Sr-O) in Sr₂Al₃Si₇ON₁₃ can be calculated from the atomic coordinates shown in Table 1.

**Table 1**

| Element | x | y | z |
|---|---|---|---|
| Sr1 | 0.27857(6) | 0.49070(3) | 0.31162(19) |
| Sr2 | 0.35525(6) | 0.69834(3) | 0.7914(3) |
| Si, Al1 | 0.35788(16) | 0.27697(9) | 0.7909(7) |
| Si, Al2 | 0.07865(16) | 0.70029(8) | 0.7915(7) |
| Si, Al3 | 0.19194(16) | 0.63952(8) | 0.3041(7) |
| Si, Al4 | 0.00358(16) | 0.54352(8) | 0.2927(7) |
| Si, Al5 | 0.55677(16) | 0.46692(8) | 0.2985(7) |
| Si, Al6 | 0.39467(17) | 0.34711(9) | 0.2903(7) |
| Si, Al7 | 0.16173(16) | 0.56553(8) | -0.1922(7) |
| Si, Al8 | 0.47243(16) | 0.60941(8) | 0.2992(8) |
| Si, Al9 | 0.1546(3) | 0.34817(13) | 0.5289(6) |
| Si, Al10 | 0.1553(3) | 0.34966(14) | 0.0231(6) |
| O, N1 | 0.0664(5) | 0.3167(3) | 0.280(2) |
| O, N2 | 0.2530(5) | 0.3749(3) | 0.283(2) |
| O, N3 | 0.2131(5) | 0.2983(3) | 0.773(2) |
| O, N4 | 0.1015(5) | 0.3996(3) | -0.235(2) |
| O, N5 | 0.4050(6) | 0.2731(3) | 0.4571(16) |
| O, N6 | 0.3621(6) | 0.2067(3) | 0.9695(17) |
| O, N7 | 0.4919(6) | 0.3985(3) | 0.4519(17) |
| O, N8 | 0.4389(6) | 0.3335(3) | 0.9582(16) |
| O, N9 | 0.3356(5) | 0.6342(3) | 0.3472(15) |
| O, N10 | 0.0545(6) | 0.5193(3) | -0.0253(17) |
| O, N11 | 0.1600(6) | 0.6423(3) | -0.0419(16) |
| O, N12 | 0.1259(6) | 0.5734(3) | 0.4586(17) |
| O, N13 | 0.4887(6) | 0.5338(3) | 0.4528(17) |
| O, N14 | 0.7036(5) | 0.4688(3) | 0.331(2) |

The yellow-emitting phosphor according to the present embodiment needs to have the above crystal structure. If the chemical bond lengths are changed more than the above, they are broken to form another crystal structure and hence the effect of the present embodiment cannot be obtained.

The yellow-emitting phosphor of the present embodiment is based on an inorganic compound having essentially the same crystal structure as Sr₂Al₃Si₇ON₁₃, but the constituting element M is partly replaced with the emission center element Ce and the content of each element is restricted to a particular range. On the basis of those conditions, the phosphor according to the present embodiment can highly efficiently exhibit an emission spectrum with a wide half-width and also can have favorable properties, such as, excellent temperature characteristics.

The phosphor of the present embodiment has a composition represented by the above formula (1), and further exhibits peaks at particular diffraction angles (2θs) in the X-ray diffraction pattern measured with Cu-Kα line radiation according to Bragg-Brendano method. Specifically, the XRD pattern thereof has at least ten peaks at the diffraction angles (2θs) of 11.1-11.3°, 15.0-15.2°, 18.25-18.45°, 19.75-19.95°, 23.0-23.2°, 24.85-25.05°, 25.55-25.75°, 25.95-26.15°, 29.3-29.5°, 30.9-31.1°, 31.6-31.8°, 33.0-33.2°, 33.6-33.8°, 33.95-34.15°, 34.35-34.55°, 35.2-35.4°, 36.05-36.25°, 36.5-36.7°, 37.2-37.4°, 38.95-39.15°, 40.45-40.65°, 42.8-43.0°, 48.3-48.5°, 48.75-48.95°, 56.4-56.6°, 64.45-64.65°, 67.55-67.75° and 68.85-69.05°

Since having a particular composition, the phosphor according to the embodiment exhibits excellent luminescent properties. That is because the phosphor of the embodiment contains carbon and thereby has an absorption spectrum with a red-shifted peak. Specifically, when excited at 450 nm, the phosphor of the embodiment has an absorption spectrum with a peak nearer to the excitation wavelength (450 nm) and accordingly can absorb the excitation light in a larger amount than known phosphors.

The yellow-emitting phosphor according to the present embodiment can be produced by the steps of mixing powdery materials containing the above elements and then firing the mixture.

The M material can be selected from the group consisting of nitride, carbonate, oxide, chloride, fluoride, silicide and carbide of M; the Al material can be selected from the group consisting of nitride, oxide, fluoride and carbide of Al; the Si material can be selected from the group consisting of nitride, oxide, fluoride and carbide of Si; and the emission center element Ce material can be selected from the group consisting of oxide, nitride, chloride, silicide, fluoride and carbonate of Ce.

In addition, nitrogen can be supplied from the above nitrides or from a nitrogen-containing firing atmosphere, and oxygen can be supplied from the above oxides or from surface oxidized films of the above nitrides.

For example, Sr₃N₂, Si₃N₄, Al₂O₃ and AIN, and CeO₂ are mixed in such feed amounts as give the aimed contents. The material Sr₃N₂ may be replaced with Sr₂N, SrN, a mixture thereof or the like. The powdery materials are preferably dry-mixed in the order from smaller weights to larger, so as to obtain homogeneous mixture powder.

The phosphor according to the present embodiment is characterized by containing carbon atoms in a particular amount. The carbon atoms can be introduced by adopting carbonates or carbides as the materials or by firing the materials in a carbon-containing atmosphere. The firing procedure in a carbon-containing atmosphere can be performed by use of a furnace equipped with a heater, heat insulating material or sleeve made of carbon materials.

The powdery materials are mixed, for example, in a mortar in a glove box. The mixture powder is placed in a crucible and then fired on particular conditions to obtain the phosphor according to the embodiment. There are no particular restrictions on the materials of the crucible, which is made of, for example, boron nitride, silicon nitride, silicon carbide, carbon, aluminum nitride, SiAlON, aluminum oxide, molybdenum or tungsten.

The powdery mixture is preferably fired under a pressure not less than the atmospheric pressure. Since the silicon nitride hardly decomposes, it is advantageous to fire the mixture under a pressure not less than the atmospheric pressure. In order to prevent the silicon nitride from decomposing at a high temperature, the pressure is preferably 5 atm or more and the firing temperature is preferably in the range of 1500 to 2000°C. If those conditions are satisfied, the aimed fired product can be obtained without suffering from troubles such as sublimation of the materials and/or of the product. The firing temperature is more preferably in the range of 1600 to 1900°C.

For the purpose of avoiding oxidation of AIN, the firing step is preferably carried out in a nitrogen atmosphere. The atmosphere may contain hydrogen in an amount of about 90 atm% or less.

After the firing step is carried out at the above temperature for 0.5 to 10 hours, the fired product is taken out of the crucible and then pulverized. The pulverized product is preferably fired again on the same conditions. If those procedures in series of taking out, pulverizing and firing again are repeated 0 to 10 times, the product can gain advantages that the crystal grains are less fused and hence that the formed powder is uniform both in composition and in crystal structure.

After the firing step, the product is subjected to after-treatment such as washing, if necessary, to obtain a phosphor according to the embodiment. The washing can be carried out, for example, by use of pure water or acid. Examples of the acid include: inorganic acids, such as sulfuric acid, nitric acid, hydrochloric acid and hydrofluoric acid; organic acids, such as formic acid, acetic acid and oxalic acid; and mixtures thereof.

After washed with acid, the product may be subjected to post-anneal treatment, if necessary. The post-anneal treatment, which can be carried out, for example, in a reductive atmosphere containing nitrogen and hydrogen, improves the crystallinity and the luminous efficiency.

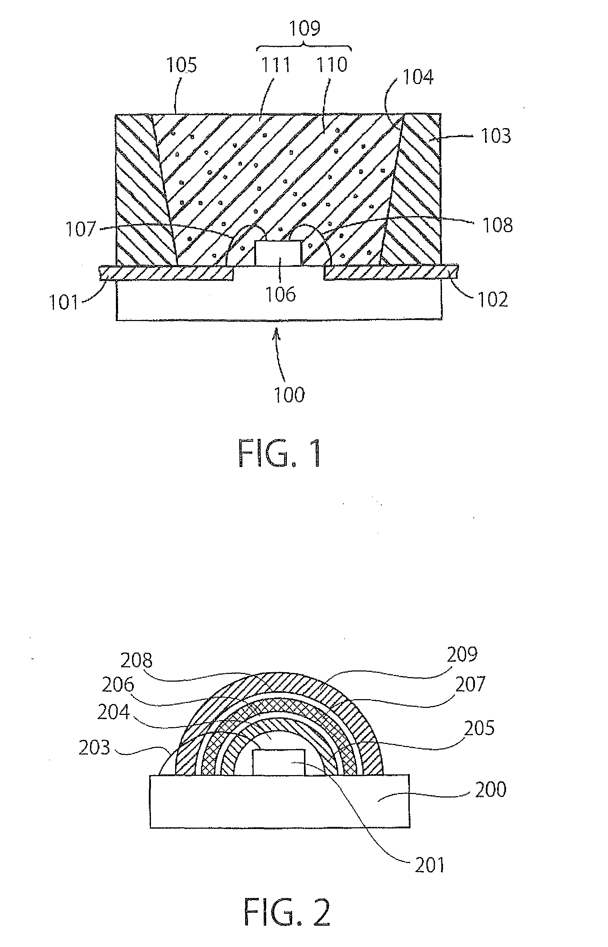

A light-emitting device of the present disclosure comprises a luminescent layer containing the above phosphor and a light-emitting element capable of exciting the phosphor. Figure 1 shows a vertical sectional view schematically illustrating a light-emitting device according to an embodiment of the present disclosure.

The light-emitting device shown in Figure 1 comprises leads 101, 102 and a package cup 103 on a substrate 100. The package cup 103 and the substrate 100 are made of resin. The package cup 103 has a concavity 105 in which the top opening is larger than the bottom. The inside wall of the concavity 105 functions as a reflective surface 104.

At the center of the nearly circular bottom of the concavity 105, there is a light-emitting element 106 mounted with Ag paste or the like. The light-emitting element 106 radiates light with a peak in the wavelength range of 400 to 500 nm. Examples of the light-emitting element include light-emitting diodes and laser diodes, such as GaN type semiconductor light-emitting chips, but they by no means restrict the light-emitting element.

The p- and n-electrodes (not shown) of the light-emitting element 106 are connected to the leads 101 and 102 by way of bonding wires 107 and 108 made of Au or the like, respectively. The positions of the leads 101 and 102 can be adequately modified.

The light-emitting element 106 may be of a flip chip type in which the n-and p-electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to adopt a light-emitting element having an n-type substrate so as to produce a light-emitting device constituted as described below. In that device, an n-electrode is formed on the back surface of the n-type substrate while a p-electrode is formed on the top surface of a p-type semiconductor layer beforehand laid on the substrate. The n-electrode is mounted on one of the leads, and the p-electrode is connected to the other lead by way of a wire.

In the concavity 105 of the package cup 103, there is a luminescent layer 109 containing the phosphor 110 according to an embodiment of the present disclosure. In the luminescent layer 109, the phosphor 110 is contained in a resin layer 111 made of, for example, silicone resin in an amount of 5 to 60 wt%. As described above, the phosphor according to the embodiment comprises Sr₂Al₃Si₇ON₁₃ matrix. Since that kind of oxynitride has high covalency, the phosphor of the embodiment is generally so hydrophobic that it has good compatibility with the resin. Accordingly, scattering at the interface between the resin and the phosphor is prevented enough to improve the light-extraction efficiency.

The yellow-emitting phosphor according to the present embodiment has good temperature characteristics, and can highly efficiently emit yellow light with a wide half-width in the emission spectrum. This phosphor is used in combination with a light-emitting element radiating light with a peak in the wavelength range of 400 to 500 nm, and thereby it becomes possible to provide a white light-emitting device excellent in luminescent properties.

The size and kind of the light-emitting element 106 and the dimension and shape of the concavity 105 can be properly changed.

The light-emitting device according to an embodiment of the present disclosure is not restricted to the package cup-type shown in Figure 1, and can be freely applied to any type of devices. For example, even if the phosphor of the embodiment is used in a shell-type or surface-mount type LED, the same effect can be obtained.

Figure 2 shows a vertical sectional view schematically illustrating a light-emitting device according to another embodiment of the present disclosure. In the shown device, p- and n-electrodes (not shown) are formed at the predetermined positions on a heat-releasing insulating substrate 200, and a light-emitting element 201 is placed thereon. The heat- releasing insulating substrate is made of, for example, AIN.

On the bottom of the light-emitting element 201, one of the electrodes of the element is provided and electrically connected to the n-electrode on the heat-releasing insulating substrate 200. The other electrode of the light-emitting element 201 is connected to the p-electrode (not shown) on the heat-releasing insulating substrate 200 by way of a gold wire 203. The light-emitting element 201 is a light-emitting diode radiating light with a peak in the wavelength range of 400 to 500 nm.

The light-emitting element 201 is successively domed with an inner transparent resin layer 204, a luminescent layer 205 and an outer transparent resin layer 206 in this order. The inner and outer transparent resin layers 204 and 206 are made of, for example, silicone resin. In the luminescent layer 205, the yellow-emitting phosphor 207 according to the present embodiment is contained in a resin layer 208.

In the production process of the light-emitting device shown in Figure 2, the luminescent layer 205, which contains the yellow-emitting phosphor of the embodiment, can be easily formed by use of techniques such as vacuum printing and drop-coating from a dispenser. Further, since positioned between the inner and outer transparent resin layers 204 and 206, the luminescent layer 205 also has the function of improving the extraction efficiency.

The luminescent layer in the light-emitting device according to the embodiment may contain not only the yellow-emitting phosphor of the embodiment but also another phosphor emitting green luminescence under excitation by blue light and still another phosphor emitting red luminescence under excitation by blue light. If comprising that luminescent layer, the produced white light-emitting device is further improved in color rendering.

Even when excited by UV light with a peak in the wavelength range of 250 to 400 nm, the yellow-emitting phosphor of the embodiment gives off yellow luminescence. Accordingly, the phosphor of the embodiment can be combined with, for example, another phosphor emitting blue light under excitation by UV light and a UV light-emitting element such as a UV light-emitting diode, to produce a white light-emitting device. In that white light-emitting device, the luminescent layer may contain not only the yellow-emitting phosphor of the embodiment but also a phosphor emitting luminescence with a peak in another wavelength range under excitation by UV light. That phosphor is, for example, a phosphor emitting red light under excitation by UV light or a phosphor emitting green light under excitation by UV light.

As described above, the phosphor according to the embodiment has good temperature characteristics, and can highly efficiently give off yellow light with a wide half-width in the emission spectrum. That yellow-emitting phosphor of the embodiment is combined with a light-emitting element radiating light with a peak in the wavelength range of 250 to 500 nm, and thereby it becomes possible to produce a white light-emitting device excellent in luminescent properties by use of fewer kinds of phosphors.

The following are concrete examples of the phosphor and the light-emitting device according to the embodiments.

### Example 1

As the materials of Sr, Ce, Si and Al, Sr₃N₂, CeO₂, Si₃N₄ and AIN were prepared and weighed out in the blending amounts of 2.851 g, 0.103 g, 5.086 g and 1.691 g, respectively, in a vacuum glove box. The powdery materials were then dry-mixed in an agate mortar.

The obtained mixture was laid in a crucible made of boron nitride (BN) and then fired at 1800°C for 1 hour under 7.5 atm in a nitrogen atmosphere. The product was taken out of the crucible, and pulverized in an agate mortar. The pulverized product was laid again in the crucible and then fired at 1800°C for 2 hours. Those procedures of taking out, pulverizing and firing again in series were further repeated twice, to obtain a phosphor of Example 1.

The obtained phosphor was in a form of yellow powder, and was observed to emit yellow luminescence when excited by black light.

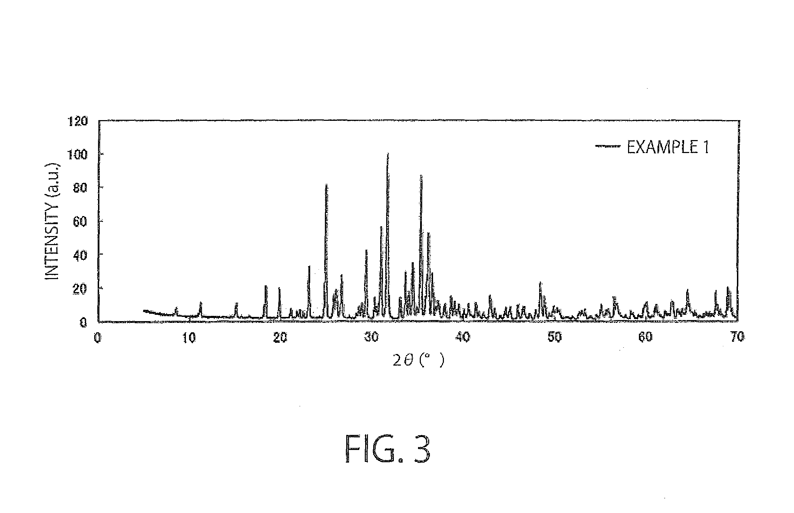

The obtained phosphor was subjected to X-ray diffraction measurement with Cu-Kα line radiation according to Bragg- Brendano method, to obtain the XRD profile shown in Figure 3. As shown in Figure 3, it was verified that there are peaks at the diffraction angles (2θs) of 11.1-11.3°, 15.0-15.2°, 18.25-18.45°, 19.75-19.95°, 23.0-23.2°, 24.85-25.05°, 25.55-25.75°, 25.95-26.15°, 29.3-29.5°, 30.9-31.1°, 31.6-31.8°, 33.0-33.2°, 33.6-33.8°, 33.95-34.15°, 34.35-34.55°, 35.2-35.4°, 36.05-36.25°, 36.5-36.7°, 37.2-37.4°, 38.95-39.15°, 40.45-40.65°, 42.8-43.0°, 48.3-48.5°, 48.75-48.95°, 56.4-56.6°, 64.45-64.65°, 67.55-67.75° and 68.85-69.05°.

Table 2 shows relative intensities of the peaks in the XRD profile of Figure 3 on the condition that the maximum peak intensity is normalized to 100.

**Table 2**

| 2*θ*(°) | Example 1 |
|---|---|
| 11.1-11.3 | 12 |
| 15.0-15.2 | 11 |
| 18.25-18.45 | 21 |
| 19.75-19.95 | 20 |
| 23.0-23.2 | 33 |
| 24.85-25.05 | 81 |
| 25.65-25.75 | 16 |
| 25.95-26.15 | 18 |
| 26.55-26.75 | 27 |
| 29.3-29.5 | 42 |
| 30.2-30.4 | 14 |
| 30.45-30.65 | 9 |
| 30.9-31.1 | 56 |
| 31.6-31.8 | 100 |
| 33.0-33.2 | 14 |
| 33.6-33.8 | 29 |
| 33.95-34.15 | 17 |
| 34.35-34.55 | 34 |
| 35.2-35.4 | 87 |
| 36.05-36.25 | 53 |
| 36.5-36.7 | 28 |
| 37.2-37.4 | 12 |
| 38.6-38.8 | 15 |
| 38.95-39.15 | 12 |
| 40.45-40.65 | 11 |
| 42.8-43.0 | 15 |
| 48.3-48.5 | 23 |
| 48.75-48.95 | 15 |
| 56.4-56.6 | 15 |
| 64.45-64.65 | 19 |
| 67.55-67.75 | 18 |
| 68.85-69.05 | 20 |

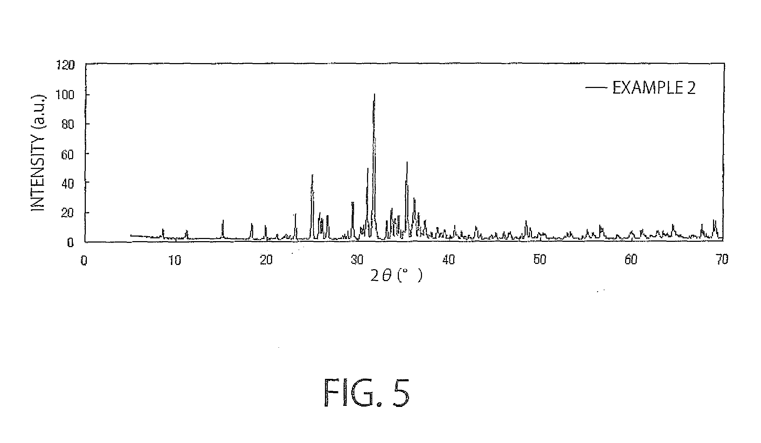

Figure 5 shows the emission spectrum of the phosphor under excitation by diffracted light of 450 nm emitted from a xenon lamp. In Figure 5, the sharp peak with a narrow half-width at 450 nm is attributed not to luminescence of the phosphor but to reflection of the excitation light. The obtained spectrum was found to have high emission intensity at the peak wavelength of 552 nm. Further, the half-width measured with a multichannel photo detector was found to be 116 nm. The half-width can be regarded as one of the indicators suggesting the color rendering property of white light given off by the light-emitting device. In general, the wider the half-width is, the easier it is to realize white light with a high color rendering property. Since the half-width was 116 nm, it was verified that the phosphor of Example 1 easily enables to realize white light with a high color rendering property.

The light-emitting element 201 was successively domed with an inner transparent resin layer 204, a luminescent layer 205 and an outer transparent resin layer 206 in this order, to produce a light-emitting device according to the embodiment. The inner transparent resin layer 204 was made of silicone resin dropped from a dispenser. The luminescent layer 205 was made of a transparent resin containing the phosphor of the present example in an amount of 50 wt%. As the transparent resin, silicone resin was adopted. On the luminescent layer 205, the outer transparent resin layer 206 was formed from silicone resin in the same manner as the inner one 204.

The produced device was placed in an integrating sphere, and then operated at 20 mA and 3.3 V, to measure the color temperature, luminous flux efficiency and Ra by means of a multichannel photo detector. As a result, the color temperature, luminous flux efficiency and Ra were found to be 6300K, 180 Im/W and 76, respectively.

In this way, the phosphor of the present example was combined with a blue-emitting LED capable of radiating light with a peak wavelength of 460 nm, to produce a white-light emitting device according to the present invention. This light emitting device makes it possible to obtain a high-power white LED excellent both in luminous efficiency and in color rendering.

### Examples 2 to 5 and Comparative example

The procedure of Example 1 was repeated except for changing the materials and the blending amounts thereof into those shown in Table 3, to produce phosphors of Examples 2 to 5. Independently, a phosphor of Comparative example was produced from the materials shown in Table 3. Specifically, the powdery materials in the amounts shown in Table 3 were weighed out and dry-mixed in a vacuum glove box. The mixture was laid in a crucible made of boron nitride (BN) and then fired at 1800°C for 1 hour under 1 atm in an ammonia atmosphere, and thereafter treated in the same manner as in Example 1 to produce the phosphor of Comparative example.

**Table 3**

| | Ex. 1 | Ex. 2 | Ex. 3 | Ex. 4 | Ex. 5 | Com. |
|---|---|---|---|---|---|---|
| Sr₃N₂ | 2.851 | 2.708 | 2.851 | 2.993 | 3.136 | 3.065 |
| CeO₂ | 0.103 | | | | 0.114 | |
| CeN | | 0.088 | | | | |
| CeCl₃ | | | 0.148 | 0.155 | | 0.155 |
| Si₃N₄ | 5.086 | 5.086 | 5.262 | 5.262 | 5.086 | 5.262 |
| AlN | 1.691 | 1.691 | 1.537 | 1.537 | 1.691 | 1.537 |
| Total | 9.731 | 9.573 | 9.797 | 9.947 | 10.026 | 10.019 |

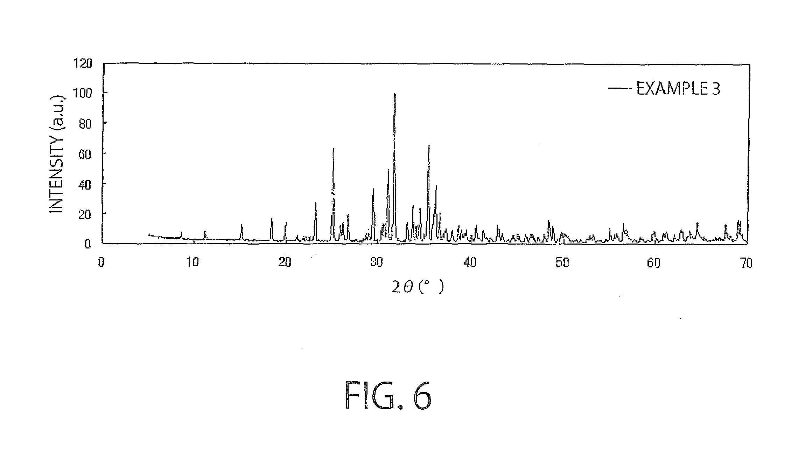

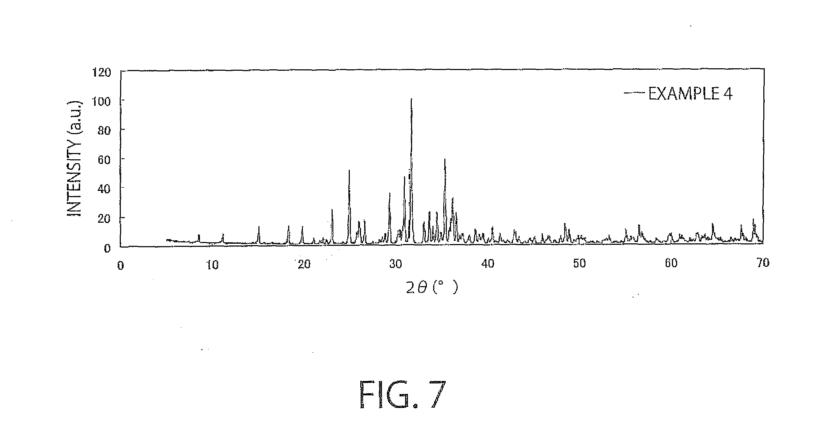

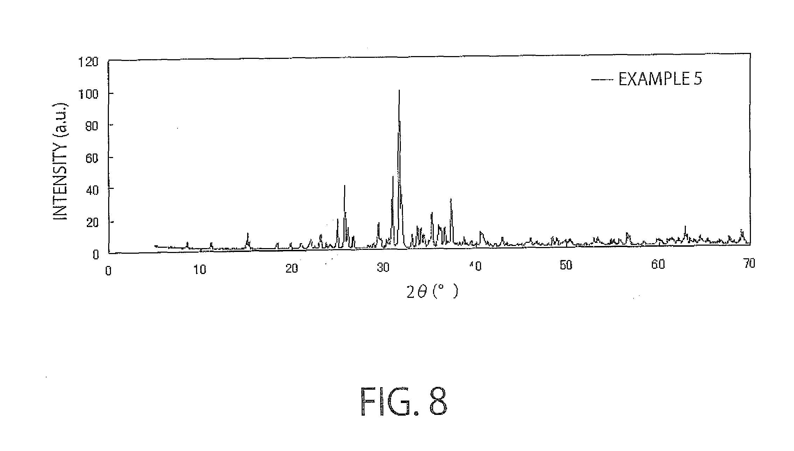

All the phosphors of Examples 2 to 5 and Comparative example were in a form of yellow powder, and were observed to emit yellow luminescence when excited by black light. Figures 5 to 8 show XRD patterns of those phosphors. Further, Table 4 shows relative intensities and diffraction angles (2θs) of the relatively strong peaks in the XRD profiles on the condition that the maximum peak intensities are normalized to 100.

**Table 4**

| 2*θ*(°) | Example 1 | Example 2 | Example 3 | Example 4 | Example 5 |
|---|---|---|---|---|---|
| 11.1-11.3 | 12 | 8 | 9 | 9 | 6 |
| 15.0-15.2 | 11 | 15 | 13 | 13 | 11 |
| 18.25-18.45 | 21 | 12 | 13 | 17 | 5 |
| 19.75-19.95 | 20 | 11 | 13 | 15 | 5 |
| 23.0-23.2 | 33 | 18 | 25 | 27 | 10 |
| 24.85-25.05 | 81 | 45 | 51 | 63 | 20 |
| 25.65-25.75 | 16 | 19 | 9 | 12 | 40 |
| 25.95-26.15 | 18 | 16 | 16 | 14 | 14 |
| 26.55-26.75 | 27 | 17 | 17 | 20 | 9 |
| 29.3-29.5 | 42 | 27 | 35 | 36 | 17 |
| 30.2-30.4 | 14 | 10 | 10 | 12 | 6 |
| 30.45-30.65 | 9 | 11 | 10 | 13 | 8 |
| 30.9-31.1 | 56 | 49 | 46 | 49 | 45 |
| 31.6-31.8 | 100 | 100 | 100 | 100 | 100 |
| 33.0-33.2 | 14 | 14 | 16 | 14 | 9 |
| 33.6-33.8 | 29 | 22 | 22 | 25 | 14 |
| 33.95-34.15 | 17 | 15 | 13 | 12 | 13 |
| 34.35-34.55 | 34 | 18 | 23 | 24 | 9 |
| 35.2-35.4 | 87 | 54 | 58 | 65 | 23 |
| 36.05-36.25 | 53 | 29 | 32 | 39 | 14 |
| 36.5-36.7 | 28 | 18 | 22 | 20 | 13 |
| 37.2-37.4 | 12 | 14 | 7 | 10 | 32 |
| 38.6-38.8 | 15 | 9 | 11 | 12 | 7 |
| 38.95-39.15 | 12 | 6 | 7 | 9 | 4 |
| 40.45-40.65 | 11 | 11 | 12 | 13 | 10 |
| 42.8-43.0 | 15 | 10 | 10 | 13 | 7 |
| 48.3-48.5 | 23 | 13 | 14 | 17 | 6 |
| 48.75-48.95 | 15 | 9 | 11 | 12 | 6 |
| 56.4-56.6 | 15 | 10 | 14 | 14 | 9 |
| 64.45-64.65 | 19 | 11 | 14 | 15 | 7 |
| 67.55-67.75 | 18 | 12 | 13 | 13 | 6 |
| 68.85-69.05 | 20 | 14 | 17 | 16 | 9 |

In the XRD patterns of all the phosphors, it was thus verified that there are peaks at the diffraction angles (2θs) of 11.1-11.3°, 15.0-15.2°, 18.25-18.45°, 19.75-19.95°, 23.0-23.2°, 24.85-25.05°, 25.55-25.75°, 25.95-26.15°, 29.3-29.5°, 30.9-31.1°, 31.6-31.8°, 33.0-33.2°, 33.6-33.8°, 33.95-34.15°, 34.35-34.55°, 35.2-35.4°, 36.05-36.25°, 36.5-36.7°, 37.2-37.4°, 38.95-39.15°, 40.45-40.65°, 42.8-43.0°, 48.3-48.5°, 48.75-48.95°, 56.4-56.6°, 64.45-64.65°, 67.55-67.75° and 68.85-69.05°.

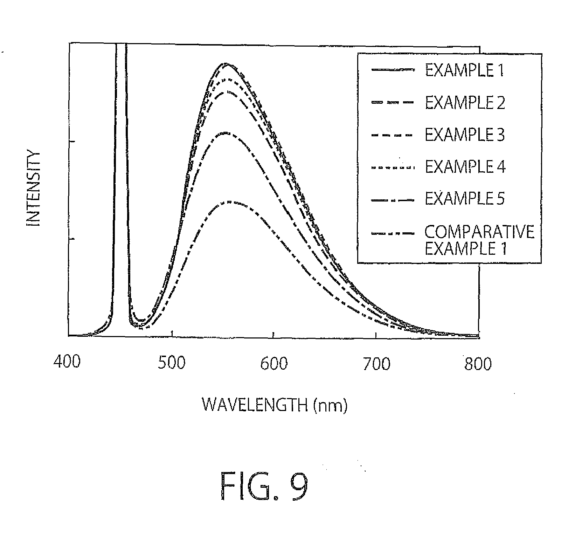

The luminescent properties of the phosphors of Examples 2 to 5 and Comparative example were evaluated in the same manner as those of Example 1. Figure 9 shows emission spectra given by the phosphors of Examples 1 to 5 under excitation at 450 nm, and Table 5 shows luminescent properties obtained from the emission spectra. The emission intensities in Table 5 are in terms of relative values provided that the intensity of Example 1 is regarded as 1.

**Table 5**

| | Wavelength (nm) | Relative rate of absorption | Relative internal quantum efficiency | Relative external quantum efficiency | Relative emission intensity | Emission half-width |
|---|---|---|---|---|---|---|
| Ex. 1 | 552 | 1.00 | 1.00 | 1.00 | 1.00 | 116 |
| Ex. 2 | 553 | 0.98 | 0.99 | 0.97 | 0.90 | 118 |
| Ex. 3 | 554 | 1.01 | 1.02 | 1.03 | 0.99 | 117 |
| Ex. 4 | 553 | 0.98 | 1.00 | 0.97 | 0.94 | 119 |
| Ex. 5 | 552 | 1.00 | 0.92 | 0.92 | 0.74 | 119 |
| Com. 1 | 557 | 0.99 | 0.55 | 0.55 | 0.50 | 124 |

As shown in Table 5, the phosphors of Examples 1 to 5 had emission peaks in the wavelength range of 550 to 560 nm and also exhibited as high emission intensities as 0.74 or more. Further, the emission half-widths thereof were as broad as 116 nm or more. On the other hand, however, the phosphor of Comparative example exhibited such insufficient brightness that the emission intensity was 0.50.

**Table 6-1**

| | Sr | Ce | Al | Si | O | N | C |
|---|---|---|---|---|---|---|---|
| Ex. 1 | 1.88 | 0.041 | 2.79 | 7.21 | 0.49 | 13.0 | 0.028 |
| Ex. 2 | 1.83 | 0.038 | 2.83 | 7.17 | 0.51 | 12.9 | 0.056 |
| Ex. 3 | 1.86 | 0.041 | 2.54 | 7.46 | 0.39 | 13.4 | 0.036 |
| Ex. 4 | 1.90 | 0.041 | 2.58 | 7.42 | 0.36 | 13.4 | 0.018 |
| Ex. 5 | 1.74 | 0.039 | 2.80 | 7.20 | 0.64 | 13.1 | 0.080 |
| Com. | 1.82 | 0.044 | 2.47 | 7.53 | 0.31 | 13.4 | 0.149 |

**Table 6-2**

| | x | y | z | u | v | w | u+v+w |
|---|---|---|---|---|---|---|---|
| Ex. 1 | 0.041 | 0.96 | 2.79 | 0.49 | 13.0 | 0.028 | 13.6 |
| Ex. 2 | 0.038 | 0.93 | 2.83 | 0.51 | 12.9 | 0.056 | 13.4 |
| Ex. 3 | 0.041 | 0.95 | 2.54 | 0.39 | 13.4 | 0.036 | 13.8 |
| Ex. 4 | 0.041 | 0.97 | 2.58 | 0.36 | 13.4 | 0.018 | 13.8 |
| Ex. 5 | 0.039 | 0.89 | 2.80 | 0.64 | 13.1 | 0.080 | 13.8 |
| Com. | 0.044 | 0.93 | 2.47 | 0.31 | 13.4 | 0.149 | 13.9 |

As evident from Table 6-2, in all the phosphors of Examples 1 to 5, x, y, z, u and w were within the following ranges:
0<x≤1,
0.8≤y≤1.1,
2≤z≤3.5,
0<u≤1.5,
0.01≤w≤0.1, and
13≤u+v+w≤15.

Those phosphors have the specified compositions, and each of them can highly efficiently emit yellow light with a wide half-width in the emission spectrum. In contrast, the phosphor of Comparative example, which cannot exhibit sufficient brightness, has as large w as 0.149.

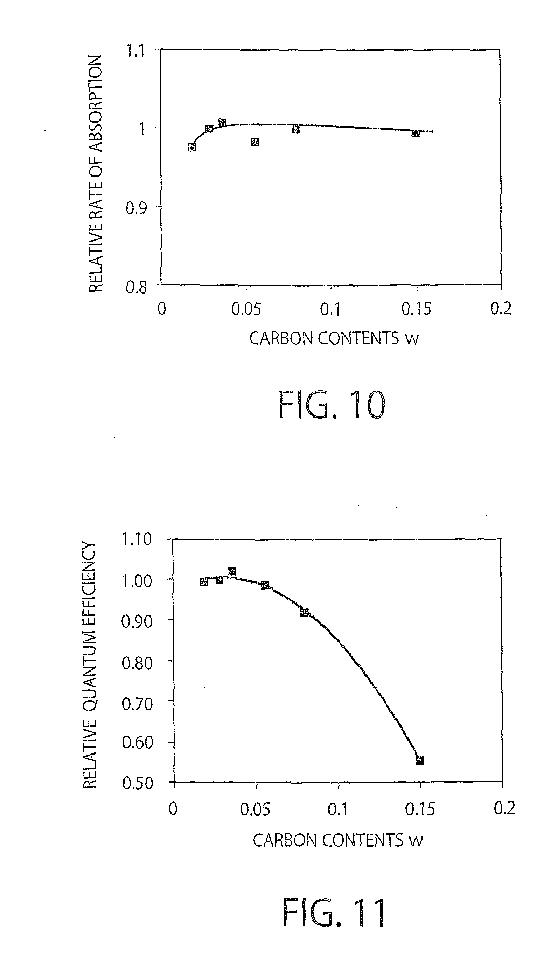

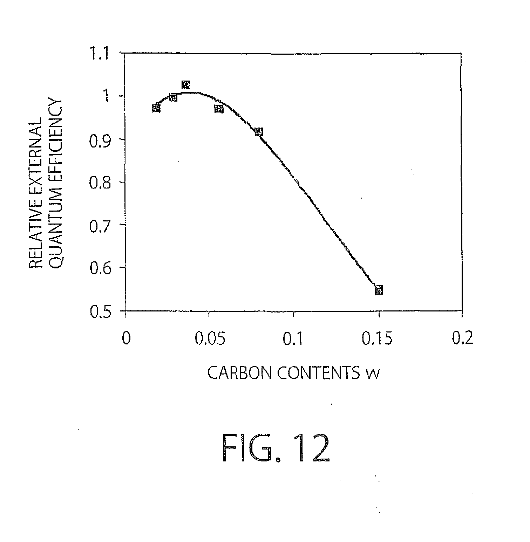

The relative rates of absorption, the relative internal quantum efficiencies and the relative external ones in Table 5 individually had relations shown in Figures 10 to 12, respectively, with the carbon contents (w) in Table 6-2.

Figure 10 indicates that the rate of absorption increases in accordance with increase of the carbon content. That is presumed to be because the increase of the carbon content enhances covalency and hence red-shifts the absorption band of the emission center element Ce³⁺ to bring the absorption band peak close to the excitation wavelength. Further, Figure 11 indicates that the internal quantum efficiency increases in accordance with decrease of the carbon content. That is presumed to be because, if the carbon content increases too much, the crystal is colored to enhance the matrix absorption. The external quantum efficiency, which is a product of the rate of absorption and the internal quantum efficiency, becomes maximum when the carbon content (w) is within the range of 0.01 to 0.1.

If y in the formula (1) is less than 0.8, the content of Sr+Ce is so small that the crystallinity lowers to impair the efficiency. On the other hand, if y is more than 1.1, the content of Sr+Ce is so large that excess of Sr+Ce may deposit in the form of variant phases to decrease the efficiency.

If u in the formula (1) is more than 1, the content of O is so large that the covalency decreases to blue-shift the luminescence, to reduce the efficiency and to impair the temperature characteristics. On the other hand, if the value of z-u is less than 1.8, the content of O is too large as compared with that of Al to keep the aimed crystal structure. As a result, the formed crystal has a structure other than the aimed one, and accordingly the aimed properties cannot be obtained.

If the value of u+v+w in the formula (1) is less than 13, the crystal contains anions in such a small amount that the charge balance cannot be kept and consequently that the formed crystal cannot have the aimed structure. In that case, since the crystal has a structure other than the aimed one, the aimed properties cannot be obtained. On the other hand, if the value of u+v+w is more than 15, the crystal contains anions in such a large amount that the charge balance cannot be kept and consequently that the formed crystal also cannot have the aimed structure. Accordingly, since the crystal has a structure other than the aimed one, the aimed properties cannot be obtained, either.

The embodiment of the present disclosure thus provides a phosphor capable of highly efficiently emitting yellow light with a wide half-width in the emission spectrum. This yellow-emitting phosphor of the embodiment can be combined with a blue LED, to obtain a white-light emitting device excellent both in luminescent properties and in color rendering.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the inventions.

## Claims

1. A phosphor which emits luminescence with a peak in the wavelength range of 500 to 600 nm under excitation by light with a peak in the wavelength range of 250 to 500 nm and which is represented by the following formula (1):
(M₁₋ₓCeₓ)_{2y}Al_{z}Si_{10-z}OᵤNᵥC_{w} (1)
in which
M is a metal element comprising Sr, and
x, y, z, u, v and w satisfy the conditions of
0<x≤1,
0.8≤y≤1.1,
2≤z≤3.5,
0<u≤1.5,
0.01≤w≤0.1, and
13≤u+v+w≤15, respectively.

2. The phosphor according to claim 1, wherein M further comprises at least one element selected from the group consisting of Ba, Ca and Mg.

3. The phosphor according to claim 1, wherein the amounts of Ba, Ca and Mg are individually 10 at.% or less based on the total amount of M.

4. The phosphor according to claim 1, having a crystal structure in which the lattice constants vary by at most ±15% from those in Sr₂Al₃Si₇ON₁₃.

5. The phosphor according to claim 1, having a crystal structure in which the chemical bond lengths of M-N and M-O vary by at most ±15% from those of Sr-N and Sr-O in Sr₂Al₃Si₇ON₁₃, respectively.

6. The phosphor according to claim 1, which exhibits at least ten peaks at the diffraction angles (2θs) of 11.1-11.3°, 15.0-15.2°, 18.25-18.45°, 19.75-19.95°, 23.0-23.2°, 24.85-25.05°, 25.55-25.75°, 25.95-26.15°, 29.3-29.5°, 30.9-31.1°, 31.6-31.8°, 33.0-33.2°, 33.6-33.8°, 33.95-34.15°, 34.35-34.55°, 35.2-35.4°, 36.05-36.25°, 36.5-36.7°, 37.2-37.4°, 38.95-39.15°, 40.45-40.65°, 42.8-43.0°, 48.3-48.5°, 48.75-48.95°, 56.4-56.6°, 64.45-64.65°, 67.55-67.75° and 68.85-69.05° in X-ray diffraction measurement with Cu-Kα line radiation according to Bragg-Brendano method.

7. A light-emitting device comprising
a light-emitting element radiating light with a peak in the wavelength range of 250 to 500 nm, and
a luminescent layer containing the phosphor according to claim 1.

8. The light-emitting device according to claim 7, wherein said luminescent layer further contains a green-light emitting phosphor and a red-light emitting one.

9. A method for producing the phosphor according to claim 1, comprising the steps of
mixing
an M material selected from the group consisting of nitride and carbide of M,
an Al material selected from the group consisting of nitride, oxide and carbide of Al,
a Si material selected from the group consisting of nitride, oxide and carbide of Si, and
a Ce material selected from the group consisting of oxide, nitride and carbonate of Ce,
to prepare a mixture; and then
firing the mixture.

10. The method according to claim 9, wherein said step of firing is carried out at a temperature of 1500 to 2000°C under 5 atm or more.

11. The method according to claim 9, wherein said step of firing is carried out in a nitrogen atmosphere.
